# EUROPEAN PATENT SPECIFICATION

(11) **EP 3 425 663 B1**
(45) Date of publication and mention of the grant of the patent: **25.01.2023**
(21) Application number: 16874083.5
(22) Date of filing: 20.05.2016
(51) Int. Cl.: H01L 21/768, H01L 21/3105

(54) **HOLE STRUCTURE AND METHOD FOR MANUFACTURING SAME, ARRAY SUBSTRATE, AND DETECTION DEVICE**
LOCHSTRUKTUR UND VERFAHREN ZUR HERSTELLUNG DAVON, ARRAY-SUBSTRAT, UND DETEKTIONSVORRICHTUNG
STRUCTURE À TROU ET SON PROCÉDÉ DE FABRICATION, SUBSTRAT DE RÉSEAU, ET DISPOSITIF DE DÉTECTION

(30) Priority: 02.03.2016 CN 201610119155
(43) Date of publication of application: 09.01.2019
(73) Proprietor: BOE Technology Group Co., Ltd., Beijing 100015 (CN); KA Imaging Inc., Kitchener, Ontario N2H 5L6 (CA)
(72) Inventor: JIANG, Feng, Beijing 100176 (CN); TIAN, Hui, Beijing 100176 (CN); ZHANG, Xiaolong, Beijing 100176 (CN); LIN, Chia Chiang, Beijing 100176 (CN)
(74) Representative: Klunker IP Patentanwälte PartG mbB
(86) International application number: PCT/CN2016/082789
(87) International publication number: WO 2017/148014

(56) References cited:
- CN-A- 101 109 879
- CN-A- 104 900 589
- CN-A- 104 979 367
- JP-A- 2000 340 652
- JP-A- 2000 340 652
- US-A1- 2012 268 678

## Description

### TECHNICAL FIELD

The present invention relates to a hole structure and a fabrication method thereof, an array substrate and a fabrication method thereof, and a detection device.

### BACKGROUND

X-ray detection device is widely applied in medical measurement, electronic industry, aerospace industry and other fields. The X-ray detection device generally comprises a scintillator and an array substrate, the array substrate is provided with a detection unit and a transistor, the scintillator converts, for example, X-ray into visible light, the detection unit receives the visible light and converts it into an electrical signal, the transistor is electrically connected with the detection unit and controls output of the electrical signal generated by the detection unit, and the outputted electrical signal for example is inputted into a display device after being processed by a circuit, so as to display an image.

JP 2000 340 652 A describes a method for manufacturing a thin film semiconductor device, wherein after forming a lower electrode on a glass substrate, an interlayer insulation film is formed to cover the lower electrode with it and after boring a first contact hole passing through the film to the lower electrode by a photo-etching in the interlayer insulation film, an organic film to be flattened is applied to the film and the lower electrode by a spin-coating method to form the flattened organic film.

US 2012/268678 A1 describes a liquid crystal display device, wherein a counter electrode is formed flatly and solidly on an organic passivation film, a pixel electrode having a slit is formed on the counter electrode via an interlayer insulation film, and an alignment film the orientation of which is controlled by optical orientation is formed on the pixel electrode The pixel electrode is connected to a source electrode through a contact hole made in a three-layer insulation, wherein the angle between the wall of the contact hole and the underlying substrate, outside of the hole, is 45 degrees or less to prevent disconnection of the pixel electrode in the contact hole.

CN 104 979 367 A describes a detector backplane comprising a substrate, a switch unit array formed on the substrate, a first electrode graph and a second electrode graph, wherein each first electrode in the first electrode graph is correspondingly connected with a switch unit in the switch unit array and forms a storage capacitor with a corresponding second electrode in the second electrode graph, and the surface, facing a photoelectric conversion layer, of each first electrode is a diffuse reflection surface.

### SUMMARY

It is an object of the present invention to provide a hole structure and a fabrication method thereof, an array substrate and a fabrication method thereof, and a detection device, so as to meet a requirement on a thickness and high-voltage withstanding capability of an insulating layer in a detection device and to reduce difficulty in fabricating the hole structure.

The object is achieved by the features of the respective independent claims. Further embodiments are defined in the corresponding dependent claims.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1a is a structural view illustrating an array substrate in an X-ray detection device according to one technique;
FIG. 1b is a structural view illustrating an array substrate in another X-ray detection device according to one technique;
FIG. 2a to FIG. 2d are schematic views illustrating first and second photolithography processes in a method provided by Embodiment One of the present disclosure, wherein the hole structure with only two thin films with holes is not according to the claims;
FIG. 2e is a cross-sectional schematic view illustrating a hole structure fabricated by using the method provided by Embodiment One of the present disclosure, wherein the hole structure with only two thin films with holes is not according to the claims;
FIG. 3a and FIG. 3b are schematic views illustrating another first photolithography process in the method provided by Embodiment One of the present disclosure, wherein the hole structure with only two thin films with holes is not according to the claims;
FIG. 4 is a cross-sectional schematic view illustrating another hole structure, which is according to the claims, fabricated by using the method provided by Embodiment One of the present disclosure;
FIG. 5a is a cross-sectional schematic view illustrating an array substrate fabricated by using a method provided by Embodiment Two of the present disclosure, wherein the hole structure with only two thin films with holes is not according to the claims; and
FIG. 5b is a cross-sectional schematic view illustrating another array substrate fabricated by using the method provided by Embodiment Two of the present disclosure, wherein the hole structure with only two thin films with holes is not according to the claims;

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure. It is obvious that the described embodiments are just a part but not all of the embodiments of the disclosure.

Unless otherwise defined, technical terms or scientific terms used in the present disclosure should be of general meaning as understood by those ordinarily skilled in the art. "First", "second" and similar words used in the present disclosure do not represent any sequence, quantity or importance and merely intend to differentiate different composite parts. Words such as "include" or "comprise" and the like denote that elements or objects appearing before the words of "include" or "comprise" cover the elements or the objects enumerated after the words of "include" or "comprise" or equivalents thereof, not exclusive of other elements or objects. Words such as "connected" or "connecting" and the like are not limited to physical or mechanical connections, but may include electrical connection, either direct or indirect. Words such as "up", "down", "left", "right" and the like are only used for expressing relative positional relationship, in the case that the absolute position is a described object is changed, the relative positional relationship may also be correspondingly changed.

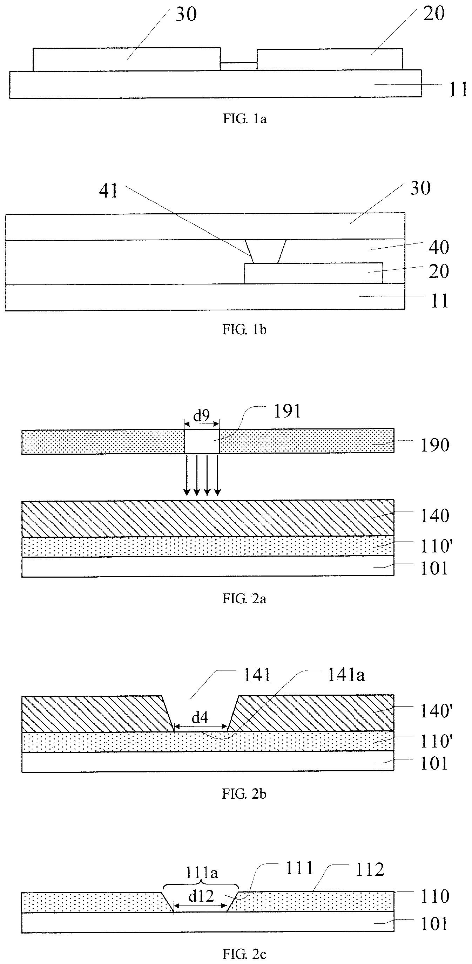

FIG. 1a is a structural view illustrating an array substrate in an X-ray detection device. As shown in FIG. 1a, the array substrate comprises a base substrate 11 and a detection unit 30 and a transistor 20 (e.g., a thin film transistor) provided on the base substrate 11 and electrically connected with each other. In this structure, since the detection unit 30 is arranged side by side with the transistor 20, a fill factor of the array substrate is lower, which in turn affects detection quality; in addition, a parallel capacitance may be generated between the detection unit and the transistor, resulting in noise generated in an electrical signal outputted by the detection unit.

In research, inventors of the present application have noted that, the X-ray detection device may use another array substrate, as shown in FIG. 1b, the detection unit 30 and the transistor 20 are sequentially arranged in a direction perpendicular to the base substrate 11, and are electrically connected with each other through a via hole 41 in an insulating layer 40, to improve the fill factor of the array substrate.

However, in the structure shown in FIG. 1b, an electrode of the detection unit 30, which is insulated from the transistor 20, is applied with a relatively high voltage (e.g., a voltage greater than or equal to 200 volts) during operation, and thus, the insulating layer 40 between the detection unit 30 and the transistor 20 needs to be able to withstand the above-described relatively high voltage, so as to reduce influence of parasitic capacitance generated between the electrode and a conductive portion of the transistor (e.g., a gate electrode, a source electrode or a drain electrode of the transistor) on the electrical signal generated by the detection unit and controlled and outputted by the transistor.

Further, since it is required to ensure that the insulating layer 40 withstands the relatively high voltage, the insulating layer needs to be fabricated thick; in addition, since a signal line connected with the electrode of the transistor is generally provided on the base substrate 11, a thicker insulating layer 40 is also needed to play a role in planarization. The thicker insulating layer 40 results in greater difficulty in fabricating the via hole 41 running through the insulating layer 40 and may result in a larger sloped angle of the via hole 41 (i.e., a relatively steeper wall of the via hole 41); and the larger sloped angle results in that an electrode material of the detection unit is not easily deposited on the wall of the via hole 41, so that connection breakage between the detection unit and the transistor is liable to occur.

The embodiments of the present disclosure provide a hole structure and a fabrication method thereof, an array substrate and a fabrication method thereof, a detection device and a display device. The fabrication method of the hole structure, as defined in appended claim 1, comprises: forming a first initial thin film on a base substrate; performing a first photolithography process on the first initial thin film with a pattern region of a mask to form a first thin film and a first hole located in the first thin film, so that the first hole has an opening on a surface of the first thin film away from the base substrate; forming a second initial thin film covering the first thin film; and performing a second photolithography process on the second initial thin film with the pattern region of the mask to form the second thin film and a second hole running through the second thin film and communicating with the first hole, so that the second hole has a first opening close to the base substrate and a second opening away from the base substrate, and a dimension of the second opening in a preset direction parallel to the base substrate is larger than a dimension of the first opening in the preset direction.

In the embodiments of the present disclosure, in one aspect, since the hole structure has a plurality of thin films, it can meet a requirement on a thickness and high-voltage withstanding capability of the insulating layer in the detection device; in addition, the photolithography process is performed respectively on the plurality of thin films with a same mask in the fabrication method of the hole structure, which thus can reduce difficulty in fabricating the hole structure while reducing a fabrication cost, and which is advantageous for the sloped angle of the hole structure to meet a design requirement.

Hereinafter, the hole structure and the fabrication method thereof, the array substrate and the fabrication method thereof, the detection device and the display device provided by the embodiments of the present disclosure will be described in detail in conjunction with the drawings.

### Embodiment One

This embodiment provides a fabrication method of a hole structure, and as shown in FIG. 2a to FIG. 2e, the method provided by this embodiment comprises step S21 to step S24 as follows:

Step S21: forming a first initial thin film 110' on a base substrate 101, as shown in FIG. 2a.

Step S22: performing a first photolithography process on the first initial thin film 110' with a pattern region 191 of a mask 190 (as shown in FIG. 2a) to form a first thin film 110 and a first hole 111 located in the first thin film 110 (as shown in FIG. 2c). In this step, the first hole 111 has an opening 111a on a surface 112 of the first thin film 110 away from the base substrate 101, as shown in FIG. 2c.

For example, the first photolithography process includes step S221 to step S224 as follows.

Step S221: forming a photoresist 140 covering the first initial thin film 110', as shown in FIG. 2a.

Step S222: exposing the photoresist 140 with the pattern region 191 of the mask 190, as shown in FIG. 2a.

Step S223: developing the exposed photoresist to form a photoresist pattern 140', and forming a photoresist via hole 141 in the photoresist pattern 140', as shown in FIG. 2b.

Step S224: etching the first initial thin film 110' with the photoresist via hole 141 in the photoresist pattern 140', to form the first thin film 110 and the first hole 111, as shown in FIG. 2c.

In this step, for example, the photoresist pattern 140' is removed after forming the first thin film 110 and the first hole 111, as shown in FIG. 2c.

After step S221 to step S224 of the first photolithography process are completed, step S23 and step S24 are performed to fabricate a second thin film and a second hole.

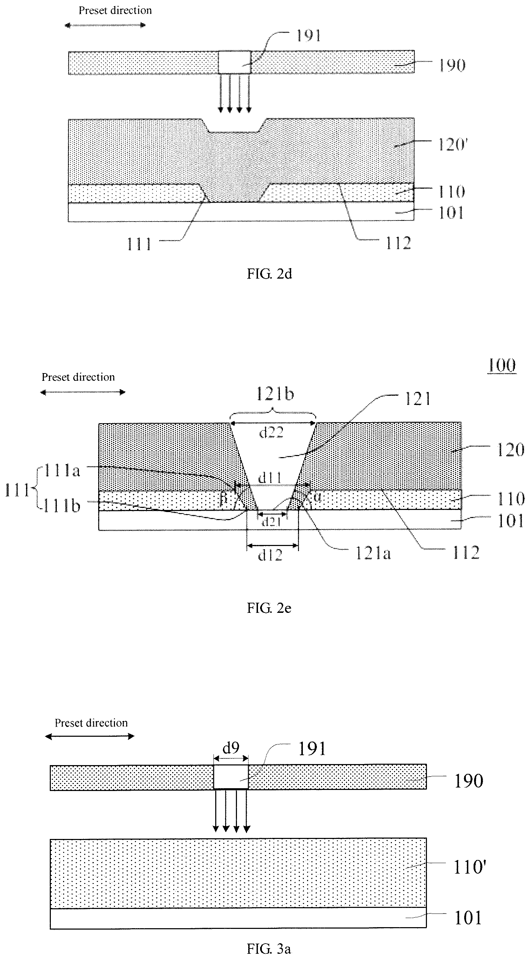

Step S23: forming a second initial thin film 120' covering the first thin film 110, as shown in FIG. 2d.

Step S24: performing a second photolithography process on the second initial thin film 120' with the pattern region 191 of the mask 190 (as shown in FIG. 2d), to form a second thin film 120 and a second hole 121 running through the second thin film 120 and communicating with (also referred to as running through) the first hole 111, so as to obtain a hole structure 100 (as shown in FIG. 2e). In this step, the second hole 121 has a first opening 121a close to the base substrate 101 and a second opening 121b away from the base substrate 101, and a dimension d22 of the second opening 121b in a preset direction (as shown by an arrow in FIG. 2e, the preset direction is any direction parallel to the base substrate 101 and is set according to actual needs) parallel to the base substrate 101 is larger than a dimension d21 of the first opening 121a in the preset direction. That is to say, the second hole 121 is a via hole (also referred to as a through hole), and a lower-end opening dimension of the second hole 121 in the preset direction is relatively small, and an upper-end opening dimension of the second hole 121 in the preset direction is relatively large.

In a normal photolithography process, during the hole structure is formed in the thin film on the base substrate with the pattern region 191 of the mask 190, an absolute value of a difference between a dimension of an end portion of the hole structure close to the base substrate and a dimension of the pattern region 191 is no larger than 4 microns (that is to say, bi-lateral bias of the hole structure is no larger than 4 microns). In this embodiment, for example, the second thin film 120 is a last thin film formed with the mask 190, in this case, an absolute value of a difference between a dimension d9 of the pattern region 191 of the mask 190 in the preset direction (as shown in FIG. 2a) and a dimension d21 of the first opening 121a of the second hole 121 (as shown in FIG. 2e) is smaller than or equal to 4 microns, so as to meet a requirement of the photolithography process.

The above-described hole structure 100 fabricated by using the fabrication method provided by this embodiment, can meet requirements on a thickness and high-voltage withstanding capability of the insulating layer in the X-ray detection device; in addition, in the method provided by this embodiment, the photolithography process is performed respectively on the plurality of thin films for forming the hole structure with a same mask, which thus can reduce difficulty in fabricating the hole structure, so that the sloped angle of the hole structure meets a design requirement and at the same time a fabrication cost is reduced.

For example, a forming material of the first thin film 110 or the second thin film 120 includes an organic material, for example, polyimide, acrylic, or other organic materials having an insulating property. By forming the first thin film or the second thin film with the organic material, the first thin film and the second thin film is capable of having a larger thickness to meet requirements on the thickness and planarization of the insulating layer in the X-ray detection device or a similar electronic device. It should be noted that, in a case where the second thin film is made of an organic material, in the above-described step S224, the step of removing the photoresist pattern may be omitted, that is, in step S23, the second initial thin film may be directly formed on the photoresist pattern.

For example, a thickness of the organic material layer is in a range of 1 micron to 3 microns (µm).

Since a thickness of the organic material layer is large, the sloped angle of the hole structure in the organic material layer has a greater influence on an overall structure of the hole structure 100; for example, in a case where the first thin film 110 includes the organic material layer, the sloped angle of the first hole 111 (i.e., an acute angle formed between the wall of the first hole and the base substrate) is smaller than or equal to 45 degrees, for example, is smaller than or equal to 35 degrees; or in a case where the second thin film 120 includes the organic material layer, the sloped angle of the second hole 121 (i.e., an acute angle formed between the wall of the second hole and the base substrate, as shown by angles α and β in FIG. 2e, where α and β may be equal or unequal) is smaller than or equal to 45 degrees, for example, is smaller than or equal to 35 degrees.

For example, the organic material has a relative dielectric constant of 3 to 4, to facilitate meeting requirements on voltage withstanding capability of the insulating layer in the X-ray detection device or the similar electronic device.

In the case that the first thin film or the second thin film is formed with the organic material (e.g., polyimide) having a property similar to photoresist, during the photolithography process is performed on the first or second thin film, a step of coating the photoresist and a step of the etching process may be omitted. For example, in the above-described step S23 and step S24, the second initial thin film 120' is made of the organic material having the property similar to photoresist, the second initial thin film 120' in FIG. 2d is exposed and then developed, and the second thin film 120 and the second hole 121 as shown in FIG. 2e is obtained, to simplify the fabrication process.

The organic material layer for example is formed by spin coating, slot die coating, or spray coating. In a case where viscosity of the organic material is known, the thickness of the organic material layer is controlled by changing a deposition condition (e.g., the number of rotation of the spin coating).

For example, the forming material of the first thin film 110 or the second thin film 120 includes an inorganic material, for example, SiNx, SiOx, SiNOx, Al₂O₃, TaN, or a similar inorganic material having an insulating property.

For example, the inorganic material has a relative dielectric constant of 7 to 8.

For example, a thickness of an inorganic material layer is smaller than or equal to 1 µm, for example, in a range of 100 nanometers (nm) to 300 nanometers.

A forming method of the inorganic material layer for example is chemical vapor deposition (CVD), pulsed magnetron sputtering, or sol-gel method. In general, quality of the insulating thin film obtained by chemical vapor deposition is more preferable, and its deposition conditions (e.g., temperature, power, gas flow rate, time, etc.) are determined according to a type of the thin film, which will not be described in detail here.

For example, one of the first thin film 110 and the second thin film 120 includes the organic material layer and the other includes the inorganic material layer. As compared with a case where both of the first thin film 110 and the second thin film 120 include the organic insulating layer, a stacking structure formed with the organic material layer and the inorganic material layer has a smaller thickness under the premise of meeting the requirements on the thickness and the voltage withstanding capability of the insulating layer, which thus facilitates fabricating the hole structure with a smaller sloped angle.

In a case that the stacking structure is formed with the inorganic material layer and the organic material layer, since an overall thickness of the stacking structure is relatively large and since properties of the inorganic material layer and the organic material layer are different, if hole structures in the inorganic material layer and the organic material layer are respectively formed in an etching step of a same photolithography process to form the hole structure running through the stacking structure, various problems are caused, for example, the sloped angle of the hole structure running through the stacking structure is excessively large, which further results in connection breakage occurring between the conductive portions electrically connected through the hole structure. In this embodiment, by performing the photolithography process respectively on the inorganic material layer and the organic material layer, a smaller sloped angle is formed, to reduce a risk of occurrence of connection breakage.

For example, the organic material and the inorganic material is etched in a dry etching mode; in the method provided by this embodiment, the etching process in the above-described step S224 for example includes a dry etching process. For example, the dry etching process is plasma etching, reactive ion etching, or the like.

For example, as shown in FIG. 2e, a dimension d21 of the first opening 121a of the second hole 121 in the preset direction is smaller than or equal to a dimension d11 of the opening 111a of the first hole 111 in the preset direction. Thus, it facilitates forming a planar wall of the second hole 121, to reduce possibility of occurrence of connection breakage of the conductive portion deposited on the wall of the second hole 121.

In order that the dimension d11 of the opening 111a of the first hole 111 is greater than the dimension d21 of the first opening 121a of the second hole 121, a larger first hole 111 is formed in the above-described first photolithography process for example by over-exposure or over-etching (i.e., the exposing process or the etching process in the above-described first photolithography process exceeds to an extent than that in a normal photolithography process).

For example, by using the over-exposure in the above-described step S222, a dimension d4 (as shown in FIG. 2b) of an end portion 141a of the photoresist via hole 141 formed in the above-described step S223 close to the base substrate 101 in the preset direction is larger than a dimension d9 (shown in FIG. 2a) of the pattern region 191 of the mask 190 in the preset direction, so as to form the larger first hole 111.

For example, in the above-described step S222, the over-exposure is implemented in a mode of increasing exposure time as compared with the exposing process in the normal photolithography process. The embodiment of the present disclosure includes, but is not limited hereto.

For example, by using the over-etching process in the above-described step S224, a dimension d12 (as shown in FIG. 2e) of an end portion 111b of the first hole 111 close to the base substrate 101 in the preset direction is larger than the dimension d9 (as shown in FIG. 2a) of the pattern region 191 of the mask 190 in the preset direction, so as to form the larger first hole 111. That is, the above-described step S224 is performed in the over-etching mode. For example, both of over-exposure and over-etching are used to form the larger first opening 111.

For example, in the above-described step S224, as compared with the etching process in the normal photolithography process, the over-etching is implemented in a mode of increasing etching time or increasing power of an etching apparatus. The embodiment of the present disclosure includes, but is not limited thereto.

In the normal photolithography process, the bi-lateral bias of the formed hole structure is no larger than 4 microns, that is to say, in the normal photolithography process, an absolute value of difference between the dimension of the pattern region 191 of the mask 190 and the dimension of the hole structure in the thin film formed with the pattern region 191 is no larger than 4 microns. However, in the embodiment of the disclosure, the first photolithography process is performed in the over-exposure and/or the over-etching mode, the absolute value of difference between the dimension d12 of the end portion 111b of the first hole 111 in the first thin film 110 close to the base substrate 101 and the dimension d9 of the pattern region 191 for example is larger than 4 microns.

Further, for example, the over-exposure mode is used, the absolute value of difference between the above-described dimension d4 (as shown in FIG. 2b) of the photoresist via hole 141 and the dimension d9 of the pattern region 191 of the mask 190 is larger than 4 microns.

In order to further ensure that the dimension d11 of the opening 111a of the first hole 111 is larger than the dimension d21 of the first opening 121a of the second hole 121, the dimension d21 of the first opening 121a of the second hole 121 in the preset direction is smaller than or equal to the dimension d12 of the end portion 111b of the first hole 111 close to the base substrate 101 in the preset direction. This structure for example is implemented by controlling an extent of over-exposure or over-etching or by other means during the first photolithography process is performed on the first initial thin film; in addition, this structure has a lower requirement on accuracy of over-exposure or over-etching.

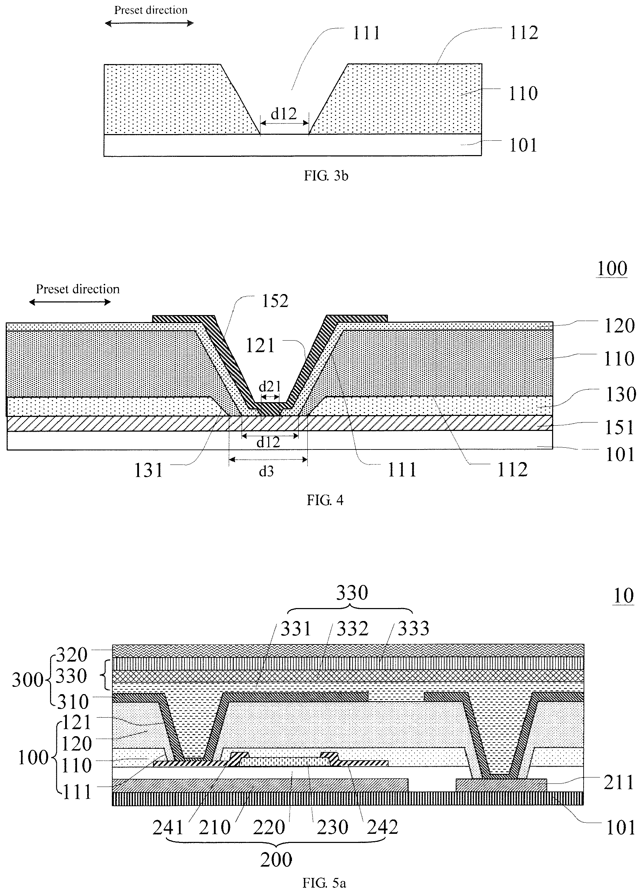

The first photolithography process includes the above step S221 to step S224, and the first photolithography process is used for fabricating the first thin film made of the organic material or the inorganic material. In addition, in the case that the first thin film is made of the organic material (e.g., polyimide) having a property similar to photoresist, the first photolithography process for example includes: exposing the first initial thin film 110' with the pattern region 191 of the mask 190, as shown in FIG. 3a; and developing the exposed first initial thin film 110', to form the first thin film 110 and the first hole 111, as shown in FIG. 3b.

For example, by controlling the exposure process, the dimension d12 (as shown in FIG. 3b) of the end portion 111b of the first hole 111 close to the base substrate 101 in the preset direction is larger than the dimension d9 (as shown in FIG. 3a) of the pattern region 191 of the mask 190 in the preset direction. For example, the first initial thin film 110' is exposed in the over-exposure mode.

For example, as shown in FIG. 4, the second thin film 120 includes a horizontal portion extending substantially parallel to the preset direction at the second hole 121. Thus, in the case that the first thin film 110 is made of the organic material, it is advantageous to reduce the requirement on accuracy of the dimension of the first hole 111 in the first thin film 110 in the photolithography process.

For example, the hole structure 100 fabricated by the method provided by this embodiment is used for implementing electrical connection between different conductive portions, in which case the first hole 111 included in the hole structure 100 is a via hole. Hereinafter, the method provided by the embodiment of the present disclosure will be described with a case where the hole structure electrically connects different conductive portions as an example.

For example, as shown in FIG. 4, the method provided by this embodiment further comprises: forming a first conductive portion 151 on the base substrate 101 before forming the first thin film 110; and forming a second conductive portion 152 on the second thin film 120 after forming the second thin film 120, so that the first conductive portion 151 and the second conductive portion 152 are electrically connected with each other through the first hole 111 and the second hole 121.

For example, both the first conductive portion and the second conductive portion are made of a material such as a metal or a conductive metal oxide.

The first conductive portion is formed on a side of the first hole 111 close to the base substrate 101 and the first conductive portion is usually formed by a wet etching; and therefore, in the case that the first thin film is over-etched by the dry etching, the first conductive portion will not be affected.

In the array substrate of the X-ray detection device, for example, the hole structure fabricated by the method provided by this embodiment is used in any one of two positions below so as to implement electrical connection between different conductive portions, and the two positions are: a position where a source electrode of the transistor (e.g., a thin film transistor) is electrically connected with a pixel electrode of the detection unit, and a position of a contact pad of the signal line (e.g., a gate line of the transistor). Therefore, for example, one of the first conductive portion and the second conductive portion as described above is the source electrode of the above-described transistor and the other is the pixel electrode of the detection unit; or, one of the first conductive portion and the second conductive portion as described above is the contact pad of the signal line, and the other is a component that is electrically connected with the contact pad. The embodiment of the present disclosure includes, but is not limited thereto.

In general, a two-layer insulating structure of the hole structure 100 can meet a requirement of the X-ray detection device on the thickness and the high-voltage withstanding capability of the insulating layer between the transistor and the detection unit. However, in the case that the second thin film is made of the organic material layer, the second conductive portion provided on a side of the second thin film away from the first thin film will be directly formed on the organic material layer; a contact property between the metal material layer for forming the second conductive portion and the organic material layer for forming the second thin film is inferior to a contact property between the metal material layer and the inorganic material layer, and the organic material layer may be damaged by a metal etching liquid and a photoresist stripping liquid, and thus, in the case that the second conductive portion is made of the metal material and the second thin film is made of the organic material layer, an inorganic material layer for example is further formed on the organic material layer, that is, the inorganic material layer is provided between the second thin film and the second conductive portion.

Before forming the second initial thin film, if a material of other thin film is formed on the wall of the first hole, it is possible to cause generation of a protrusion on the wall of the second hole in the second thin film due to the material, and further cause breakage of the conductive portion formed on the wall of the second hole. Thus, in at least one example of this embodiment, the first thin film 110 and the second thin film 120 is directly adjacent at a position corresponding to the first hole.

In the case that it is necessary to fabricate the hole structure 100 having three thin films as shown in FIG. 4, according to the claims, by using the fabrication method provided by this embodiment, the method further comprises: before forming the first thin film 110, forming a third thin film 130 on the base substrate 101and forming a third hole 131 located in the third thin film 130. For example, the photolithography process for forming the third thin film 130 includes an over-exposure process or an over-etching process.

For example, both the second thin film 120 and the third thin film 130 are the inorganic material layer, and the first thin film 110 is the organic material layer.

Hereinafter, the method provided by this embodiment will be described in detail, with a case where the pattern region of the mask in the preset direction has a dimension of 8 microns and the hole structure 100 shown in FIG. 4 is fabricated with the mask as an example.

In a case where the second thin film 120 and the third thin film 130 in the hole structure 100 shown in FIG. 4 are inorganic material layers and the first thin film 110 is organic material layer, the method for example comprises step S41 to step S43 as follows:
Step S41: forming the third thin film 130 and the third hole 131 located in the third thin film 130 on the base substrate 101 on which the first conductive portion 151 is formed.

With a case where the third thin film 130 is an SiNx inorganic insulating layer with a thickness of about 200 nm as an example, an SiNx insulating thin film is deposited by using, for example, a plasma enhanced chemical vapor deposition (PECVD) method, and then the SiNx insulating thin film is patterned with the above described mask and photoresist, to form the SiNx inorganic insulating layer.

In the patterning process, for example, by using the pattern region of the mask having a design value of 8 microns as described above, by using a dry etching process, and by using an over-etching mode, the third hole 131 with a diameter (i.e., a dimension d3 of the end portion of the third hole 131 close to the base substrate 101 in the preset direction as shown in FIG. 4) of 15 microns is formed.

In the patterning process as described above, bi-lateral bias of the third hole 131 formed by etching reaches 7 microns. In general, the bi-lateral bias of 7 microns does not meet a requirement of process design, mainly because a greater bias may cause problems such as connection breakage and short circuit. However, in the hole structure 100 shown in FIG. 4, since an area of the first conductive portion 151 below the third thin film 130 completely covers an area of an end of the third hole 131 close to the base substrate, and since the first thin film 110 made of the organic material further covers above the third thin film 130 and the organic material will fill an over-etched portion in the third hole 131, and thus it is allowable that the third hole has the above-described bi-lateral bias.

Step S42: forming the first thin film 110 and the first hole 111 located therein and communicating with the third hole 131 on the third thin film 130, with the pattern region of the mask used in step S41.

With a case where the first thin film 110 is a polyimide (PI) film with a thickness of 1.5 microns as an example, polyimide that is capable of being photoetched is coated by using, for example, a spin coating process, to form the PI film. Thus, the hole structure is formed in the PI film directly by exposure and development of the photolithography process, and then the PI film is cured, for example, in air at a temperature of 230 °C to 250 °C, to form the first hole 111 located in the first thin film 110, so as to avoid the step of the etching process.

For example, the above-described PI film with the thickness of about 1.5 microns is formed by setting the number of rotation of the spin coating. The PI film used has capability of withstanding a breakdown voltage of 350 kV/mm, and thus, the PI film with the thickness of 1.5 microns withstands a voltage of about 500 V, so that the first thin film, the second thin film and the third thin film in the hole structure 100 as a whole meet a requirement of capability of withstanding a breakdown voltage of 200 V.

For example, by controlling an exposure amount in the exposure process, a hole with a diameter of about 10 microns to 12 microns (i.e., the dimension d12 of the end portion of the first hole 111 close to the base substrate 101 in the preset direction, as shown in FIG. 4) is formed in the above-described PI film with the thickness of about 1.5 microns, and a sloped angle of the hole is approximately 35 degrees to 45 degrees.

In this step, the bi-lateral bias of the first hole 111 formed in the PI film is about 2 microns to 4 microns, which meets the requirement of the process design.

Step S43: forming a second thin film 120 and a second hole 121 located therein and communicating with the first hole 111 on the first thin film 110, with the pattern region of the mask used in step S41, as shown in FIG. 4.

For example, after forming the PI film in step S42 as described above, an inorganic insulating film is formed on the PI film, for example, a SiNx film with a thickness of about 100 nm to 200 nm is formed.

For example, the above-described SiNx film is deposited by using a low-temperature CVD method. During a process of forming the SiNx film, a deposition temperature is, for example, below 220 °C, to ensure that the deposition temperature does not destroy the PI film.

Then, the SiNx film is patterned by using a photolithography process, and the SiNx material in the first hole 111 is removed by, for example, a dry etching process, so as to expose a surface of the first conductive portion 151 at the bottom and to form the second hole 121, and a diameter of the second hole 121 (i.e., the dimension d21 of the first opening of the second hole 121 close to the base substrate 101 in the preset direction, as shown in FIG. 4) is about 8 microns to 9 microns, that is, the bi-lateral bias is about 0 micron to 1 micron, which meets the requirement of the process design.

After completion of the above-described step S41 to step S43, by depositing a metal layer on the second thin film 120, a very good adhesion property can be obtained, to ensure normal progress of subsequent process steps.

### Embodiment Two

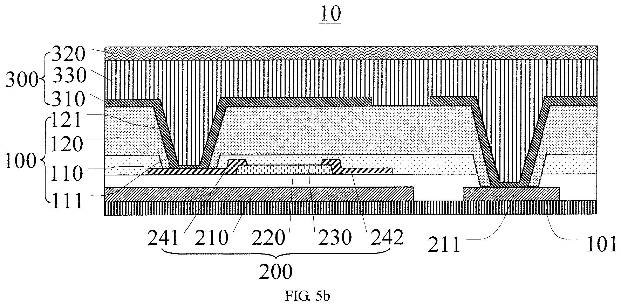

This embodiment provides a fabrication method of an array substrate 10, the method comprising: forming a hole structure 100, which is fabricated by using the method provided by Embodiment One. In addition, as shown in FIG. 5a and FIG. 5b, the method further comprises: forming a first electronic component 200 on the base substrate 101 before forming the first thin film 110 of the hole structure 100; and forming a second electronic component 300 on the base substrate 101 after forming the second thin film 120 of the hole structure 100, so that the second electronic component 300 and the first electronic component 200 are electrically connected with each other through the hole structure 100, and one of the first electronic component 200 and the second electronic component 300 including a transistor and the other including a detection unit, the detection unit being a photodetector or a radiation detector, that is, the detection unit being capable of converting ray or light into an electrical signal during operation, and the transistor being configured to control output of the electrical signal.

FIG. 5a and FIG. 5b are illustrated with a case where the first electronic component 200 is the transistor and the second electronic component 300 is the detection unit as an example. It is also possible that the first electronic component 200 is the detection unit and the second electronic component 300 is the transistor.

For example, the above-described transistor is a thin film transistor, which includes a gate electrode 210, a gate insulating layer 220, an active layer 230, a source electrode 241 and a drain electrode 242. A structure of the transistor shown in FIG. 5a and FIG. 5b is only used for illustration, and the embodiment of the present disclosure includes, but is not limited thereto.

For example, as shown in FIG. 5a and FIG. 5b, the above-described detection unit includes a pixel electrode 310, a common electrode 320 and a semiconductor structure 330; the pixel electrode 310 is formed on the base substrate 101 and is electrically connected with the transistor through the hole structure 100; the common electrode 320 is formed on the base substrate 101 and is insulated from the transistor; the semiconductor structure 330 is formed between the pixel electrode 310 and the common electrode 320 in a direction perpendicular to the base substrate 101.

In the array substrate 10 shown in FIG. 5a, the detection unit for example is a PIN-type detection unit, in which case the semiconductor structure 330 includes, for example, a P-type amorphous silicon layer 331, an intrinsic amorphous silicon layer 332 and an N-type amorphous silicon layer 333. In the array substrate 10 shown in FIG. 5b, the detection unit for example is a detection unit of a Metal-Semiconductor-Metal (MSM) type. The embodiment of the present disclosure includes, but is not limited thereto, as long as it meets a condition that the common electrode of the detection unit and the transistor overlap in a direction perpendicular to the base substrate 101 so that it is necessary to use an insulating layer which can withstand a higher breakdown voltage therebetween.

Since a working voltage of the common electrode 320 of the detection unit is relatively great, it is necessary to meet a condition that the insulating layer in the hole structure 100 is capable of withstanding the working voltage of the common electrode 320 in the case that the detection unit is electrically connected with the transistor through the hole structure 100. For example, the working voltage of the common electrode 320 is greater than or equal to 200 volts.

For example, the array substrate 10 further comprises a signal line 211 or other structure. It will not be repeated here.

### Embodiment Three

This embodiment provides a hole structure 100, as defined in appended claim 11; as shown in FIG. 2e wherein the hole structure with only two thin films with holes is not according to the claims; and FIG. 4, which is according to the claims, the hole structure 100 comprises a base substrate 101, a first thin film 110 and a second thin film 120; the first thin film 110 is provided on the base substrate 101 and has a first hole 111 formed therein, the first hole 111 has an opening 111a (not shown in FIG. 4) on a surface 112 of the first thin film 110 away from the base substrate 101; the second thin film 120 covers the first thin film 110 and has a second hole 121 formed therein, the second hole 121 communicating with the first hole 111 and running through the second thin film 120, the second hole 121 having a first opening 121a (not shown in FIG. 4) close to the base substrate 101 and a second opening 121b (not shown in FIG. 4) away from the base substrate 101; a dimension d21 of the first opening 121a in a preset direction (as indicated by an arrow in FIG. 2e) parallel to the base substrate 101 is smaller than or equal to a dimension d11 (not shown in FIG. 4) of the opening 111a of the first hole 111 in the preset direction, and a dimension d22 (not shown in FIG. 4) of the second opening 121b in the preset direction is larger than a dimension d21 of the first opening 121a.

In one aspect, since the hole structure provided by this embodiment has a plurality of thin films, it can meet a requirement on a thickness and high-voltage withstanding capability of the insulating layer in the X-ray detection device; in another aspect, since the dimension d21 of the first opening 121a of the second hole 121 in the second thin film 120 is smaller than the dimension d11 of the opening 111a of the first thin film 110, the second hole and the first hole are formed by different photolithography processes, which, as compared with a case where the first hole and the second hole are formed in a same photolithography process at a same time, can reduce difficulty in fabricating the hole structure, and is advantageous for the sloped angle of the hole structure to meet a design requirement; in still another aspect, the dimension of the first hole is fabricated relatively large, which facilitates forming a planar wall of the second hole, to reduce possibility of occurrence of connection breakage of the conductive material deposited on the wall of the second hole just because the wall is not planar.

For example, the hole structure 100 provided by this embodiment is fabricated by using the method provided by Embodiment One.

For example, the second thin film 120 includes a portion located in the first hole 111. For example, as shown in FIG. 2e, a portion of the second hole 121 is embedded within the first hole 111, so that the first hole is better communicated with the second hole.

For example, the second hole 121 extends at least to the end of the first hole 111 close to the base substrate 101. This facilitates forming a relatively planar wall of the second hole, to reduce possibility of occurrence of connection breakage just because the wall is not planar; in addition, since the first hole is fabricated relatively large, it is possible to lower a requirement on fabrication accuracy of the first hole.

For example, the dimension d21 of the first opening 121a of the second hole 121 in the preset direction is smaller than or equal to the dimension d12 of an end portion 11 1b of the first hole 111 close to the base substrate 101 in the preset direction. In this way, it can ensure that the dimension d11 of the opening 111a of the first hole 111 is large than the dimension d21 of the first opening 121a of the second hole 121 during the process of fabricating the hole structure 100.

For example, a forming material of the first thin film 110 or the second thin film 120 includes an organic material, to meet requirements on a thickness and planarization of the insulating layer in the X-ray detection device or a similar electronic device.

For example, one of the first thin film 110 and the second thin film 120 includes an organic material layer and the other includes an inorganic material layer. As compared with a case where both of the first thin film 110 and the second thin film 120 include the organic insulating layer, a stacking structure formed with the organic material layer and the inorganic material layer has a smaller thickness under the premise of meeting the requirements on the thickness and the voltage withstanding capability of the insulating layer, which thus facilitates fabricating the hole structure with a smaller sloped angle.

For the hole structure provided by this embodiment, related description in the fabrication method provided by Embodiment One may be referred to, which will not be repeated here.

### Embodiment Four

This embodiment provides an array substrate 10 as defined in claim 12; as shown in FIG. 5a and FIG. 5b, wherein the hole structure with only two thin films with holes is not according to the claims, the array substrate 10 comprising the hole structure 100 provided by Embodiment One, the first electronic component 200 and the second electronic component 300; the first electronic component 200 is provided between the base substrate 101 and the first thin film 110 of the hole structure 100 in a direction perpendicular to the base substrate 101; the second electronic component 300 is provided on a side of a second thin film 120 of the hole structure 100 away from the first thin film 110, and is electrically connected with the first electronic component 200 through the hole structure 100; and one of the first electronic component 200 and the second electronic component 300 includes a transistor and the other includes a detection unit, the detection unit being a photodetector or a radiation detector, that is, the detection unit converting ray or light into an electrical signal during operation, and the transistor being configured to control output of the electrical signal.

For example, the array substrate is fabricated by using the method provided by Embodiment Two. For the array substrate provided by this embodiment, related description in the fabrication method provided by Embodiment Two may be referred to, which will not be repeated here.

### Embodiment Five

This embodiment provides a detection device, as defined in claim 13, comprising the array substrate 10 provided by Embodiment Four.

For example, the detection device further comprises a scintillator, the scintillator is provided at an incident end of the detection unit in the array substrate 10 (i.e., an end portion of the detection unit for receiving ray or light), and is used for converting ray into light, and then the detection unit in the array substrate 10 is capable of sensing the converted light and generating a corresponding electrical signal. For example, by selecting a type of the scintillator, the detection device provided by this embodiment may be used for detecting different rays, for example, X-ray or γ-ray.

In some examples, the detection device for example further comprises a circuit, for processing the electrical signal generated by the detection unit.

### Embodiment Six

This embodiment, which is not according to the claims, provides a display device, comprising the hole structure 100 provided by Embodiment Three.

With a case where the display device according to this embodiment, which is not according to the claims, is a liquid crystal display device as an example, the display device for example comprises an array substrate, an opposed substrate and a liquid crystal layer sandwiched therebetween. For example, the array substrate includes a transistor and a pixel electrode electrically connected with each other through the hole structure provided by Embodiment Three; and/or, the array substrate includes a common electrode and a common electrode line electrically connected with each other through the hole structure provided by Embodiment Three.

For example, the display device provided by this embodiment, which is not according to the claims, may be: a liquid crystal panel, an E-paper, an OLED (organic light-emitting diode) panel, a cell phone, a tablet computer, a television, a monitor, a notebook computer, a digital frame, a navigator or any other product or part having a display function.

## Claims

1. A fabrication method of a hole structure, the method comprising:
forming a first initial thin film (110') made of organic insulating material on a base substrate (101);
performing a first photolithography process on the first initial thin film (110') with a pattern region (191) of a mask (190) to form a first thin film (110) and a first hole (111), which is a through-hole located in the first thin film (110), wherein, the first hole (111) has an opening (111a) on a surface (112) of the first thin film (110) away from the base substrate (101);
forming a second initial thin film (120') made of inorganic insulating material covering the first thin film (110); and
performing a second photolithography process on the second initial thin film (120') with the pattern region (191) of the mask (190) to form a second thin film (120) and a second hole (121), which is a through-hole running through the second thin film (120) and communicating with the first hole (111), wherein, the second hole (121) has a first opening (121a) close to the base substrate (101) and a second opening (121b) away from the base substrate (101), and a dimension (d22) of the second opening (121b) in a preset direction parallel to the base substrate (101) is larger than a dimension (d21) of the first opening (121a) in the preset direction; before forming the first thin film (110), forming a third thin film (130), made of inorganic insulating material, on the base substrate (101), such that the third thin film (130), the first thin film (110) and the second thin film (120) are disposed in this order on the same side of the base substrate (101), the third thin film (130) being closest to the base substrate (101), and forming a third hole (131), which is a through-hole located in the third thin film (130) and communicates with the first hole (111) on the base substrate (101) such that the walls of the third hole are covered by the first thin film (110);
wherein
a dimension (d12) of an end portion (111b) of the first hole (111) close to the base substrate (101) in the preset direction is smaller than a dimension (d3) of an end portion of the third hole (131) close to the base substrate (101) in the preset direction; and
a sloped angle of the first hole (111), which is the angle formed between the wall of the hole and the base substrate outside of the hole, is smaller than or equal to 45.

2. The fabrication method according to claim 1, wherein the dimension (d21) of the first opening (121a) of the second hole (121) in the preset direction is smaller than or equal to a dimension (d11) of the opening (111a) of the first hole (111) in the preset direction.

3. The fabrication method according to claim 2, wherein the dimension (d21) of the first opening (121a) of the second hole (121) in the preset direction is smaller than or equal to a dimension (d12) of an end portion (111b) of the first hole (111) close to the base substrate (101) in the preset direction.

4. The fabrication method according to any one of claims 1 to 3, wherein
an absolute value of a difference between a dimension (d9) of the pattern region (191) of the mask (190) in the preset direction and the dimension (d21) of the first opening (121a) of the second hole (121) is smaller than or equal to 4 microns.

5. The fabrication method according to claim 1 or 2, wherein
the first photolithography process includes: forming a photoresist (140) covering the first initial thin film (110'); exposing the photoresist (140) with the pattern region (191) of the mask (190); developing the exposed photoresist to form a photoresist pattern (140'), a photoresist via hole (141) being formed in the photoresist pattern (140'); and etching the first initial thin film (110') with the photoresist via hole (141) in the photoresist pattern (140') by an etching process, to form the first thin film (110) and the first hole (111), and
a dimension (d4) of an end portion (141a) of the photoresist via hole (141) close to the base substrate (101) in the preset direction is larger than the dimension (d9) of the pattern region (191) of the mask (190) in the preset direction, or the dimension (d12) of the end portion (111b) of the first hole (111) close to the base substrate (101) in the preset direction is made larger than the dimension (d9) of the pattern region (191) of the mask (190) in the preset direction by the etching process.

6. The fabrication method according to claim 1 or 2, wherein
the first photolithography process includes: exposing the first initial thin film (110') with the pattern region (191) of the mask (190) by an exposing process; and developing the exposed first initial thin film to form the first thin film (110) and the first hole (111),
a dimension (d12) of an end portion (111b) of the first hole (111) close to the base substrate (101) in the preset direction is made larger than the dimension (d9) of the pattern region (191) of the mask (190) in the preset direction by the exposing process.

7. The fabrication method according to any one of claims 1 to 6, further comprising:
before forming the third thin film (130), forming a first conductive portion (151) on the base substrate (101); and
after forming the second thin film (120), forming a second conductive portion (152) on the second thin film (120), wherein, the first conductive portion (151) and the second conductive portion (152) are electrically connected with each other through the third hole (131), the first hole (111) and the second hole (121).

8. A fabrication method of an array substrate comprising:
forming a hole structure (100) by using the method according to any one of claims 1 to 7;
before forming the third thin film (130) of the hole structure (100), forming a first electronic component (200) on the base substrate (101); and
after forming the second thin film (120) of the hole structure (100), forming a second electronic component (300) on the base substrate (101), wherein
the second electronic component (300) and the first electronic component (200) are electrically connected with each other through the hole structure (100); and
one of the first electronic component (200) and the second electronic component (300) includes a transistor and the other includes a detection unit, and the detection unit is a photodetector or a radiation detector.

9. The fabrication method according to claim 8, wherein the detection unit includes:
a pixel electrode (310), formed on the base substrate (101) and electrically connected with the transistor through the hole structure (100);
a common electrode (320), formed on the base substrate (101) and insulated from the transistor; and
a semiconductor structure (330), formed between the pixel electrode (310) and the common electrode (320) in a direction perpendicular to the base substrate (101).

10. A hole structure comprising:
a base substrate (101);
a first thin film (110), made of organic insulating material provided on the base substrate (101) and having a first hole (111), which is a through-hole formed therein, wherein, the first hole (111) has an opening (111a) on a surface (112) of the first thin film (110) away from the base substrate (101); and
a second thin film (120), made of inorganic insulating material covering the first thin film (110) and having a second hole (121), which is a through-hole formed therein, the second hole (121) communicating with the first hole (111) and running through the second thin film (120), wherein, the second hole (121) has a first opening (121a) close to the base substrate (101) and a second opening (121b) away from the base substrate (101), a dimension (d21) of the first opening (121a) in a preset direction parallel to the base substrate (101) is smaller than or equal to a dimension of the opening of the first hole (111) in the preset direction, and is smaller than a dimension (d22) of the second opening (121b) in the preset direction; a third thin film (130) made of inorganic insulating material which is disposed on the base substrate (101),
a third hole (131), which is a through-hole located in the third thin film (130), wherein the first thin film (110) is arranged between the third thin film (130) and the second thin film (120) and the first thin film (110), the second thin film (120) and the third thin film (130) are disposed on the same side of the base substrate (101) such that the third thin film (130) is closest to the base substrate (101), and, the first hole (111) communicates with the third hole (131) such that the first thin film (110) covers the walls of the third hole (131),
wherein
a dimension (d12) of an end portion (111b) of the first hole (111) close to the base substrate (101) in the preset direction is smaller than a dimension (d3) of an end portion of the third hole (131) close to the base substrate (101) in the preset direction; and a sloped angle of the first hole (111), which is the angle formed between the wall of the hole and the base substrate outside of the hole, is smaller than or equal to 45 degrees.

11. An array substrate comprising:
the hole structure (100) according to claim 10;
a first electronic component (200), provided between the base substrate (101) and the third thin film (130) of the hole structure (100) in a direction perpendicular to the base substrate (101); and
a second electronic component (300), provided on a side of the second thin film (120) of the hole structure (100) away from the first thin film (110), and electrically connected with the first electronic component (200) through the hole structure (100),
wherein one of the first electronic component (200) and the second electronic component (300) includes a transistor and the other includes a detection unit, and the detection unit is a photodetector or a radiation detector.

12. A detection device comprising the array substrate according to claim 11.

## Patentansprüche

1. Verfahren zur Herstellung einer Lochstruktur, wobei das Verfahren aufweist:
Bilden einer ersten initialen Dünnschicht (110') aus organischem Isolationsmaterial auf einem Basis-Substrat (101);
Durchführen eines ersten Photolithographieprozesses an der ersten initialen Dünnschicht (110') mit einem Strukturierungsbereich (191) einer Maske (190), um eine erste Dünnschicht (110) und ein erstes Loch (111) zu bilden, das ein Durchgangsloch ist, das in der ersten Dünnschicht (110) angeordnet ist, wobei das erste Loch (111) eine Öffnung (111a) auf einer Oberfläche (112) der ersten Dünnschicht (110) weg von dem Basis-Substrat (101) aufweist;
Bilden einer zweiten initialen Dünnschicht (120') aus anorganischem Isolationsmaterial, die die erste Dünnschicht (110) bedeckt; und
Durchführen eines zweiten Photolithographieprozesses an der zweiten initialen Dünnschicht (120') mit dem Strukturbereich (191) der Maske (190), um eine zweite Dünnschicht (120) und ein zweites Loch (121) zu bilden, das ein Durchgangsloch ist, das durch die zweite Dünnschicht (120) verläuft und mit dem ersten Loch (111) in Verbindung steht, wobei, das zweite Loch (121) eine erste Öffnung (121a) nahe dem Basis-Substrat (101) und eine zweite Öffnung (121b) weg von dem Basis-Substrat (101) aufweist, und eine Abmessung (d22) der zweiten Öffnung (121b) in einer vorgegebenen Richtung parallel zu dem Basis-Substrat (101) größer ist als eine Abmessung (d21) der ersten Öffnung (121a) in der vorgegebenen Richtung;
vor dem Bilden der ersten Dünnschicht (110), Bilden einer dritten Dünnschicht (130) aus anorganischem Isolationsmaterial auf dem Basis-Substrat (101), derart, dass die dritte Dünnschicht (130), die erste Dünnschicht (110) und die zweite Dünnschicht (120) in dieser Reihenfolge auf der gleichen Seite des Basis-Substrats (101) angeordnet sind, die dritte Dünnschicht (130) dem Basis-Substrat (101) am nächsten ist und ein drittes Loch (131) bildet, das ein Durchgangsloch ist, das sich in der dritten Dünnschicht (130) befindet und derart mit dem ersten Loch (111) auf dem Basis-Substrat (101) in Verbindung steht, dass die Wände des dritten Lochs von der ersten Dünnschicht (110) bedeckt sind;
wobei
eine Abmessung (d12) eines Endabschnitts (111b) des ersten Lochs (111) nahe dem Basis-Substrat (101) in der voreingestellten Richtung kleiner ist als eine Abmessung (d3) eines Endabschnitts des dritten Lochs (131) nahe dem Basis-Substrat (101) in der voreingestellten Richtung; und
ein Neigungswinkel des ersten Lochs (111), welcher der Winkel ist, der zwischen der Wand des Lochs und dem Basis-Substrat außerhalb des Lochs gebildet wird, kleiner als oder gleich 45 Grad ist.

2. Herstellungsverfahren nach Anspruch 1, wobei die Abmessung (d21) der ersten Öffnung (121a) des zweiten Lochs (121) in der voreingestellten Richtung kleiner als oder gleich einer Abmessung (d11) der Öffnung (111a) des ersten Lochs (111) in der voreingestellten Richtung ist.

3. Herstellungsverfahren nach Anspruch 2, wobei die Abmessung (d21) der ersten Öffnung (121a) des zweiten Lochs (121) in der voreingestellten Richtung kleiner oder gleich einer Abmessung (d12) eines Endabschnitts (111b) des ersten Lochs (111) nahe dem Basis-Substrat (101) in der voreingestellten Richtung ist.

4. Herstellungsverfahren nach einem der Ansprüche 1 bis 3, wobei
ein Absolutbetrag einer Differenz zwischen einer Abmessung (d9) des Strukturbereichs (191) der Maske (190) in der voreingestellten Richtung und der Abmessung (d21) der ersten Öffnung (121a) des zweiten Lochs (121) kleiner als oder gleich 4 Mikrometer ist.

5. Herstellungsverfahren nach Anspruch 1 oder 2, wobei
der erste Photolithographieprozess aufweist: Bilden eines Fotolacks (140), der die erste initiale Dünnschicht (110') bedeckt; Belichten des Fotolacks (140) mit dem Strukturbereich (191) der Maske (190); Entwickeln des belichteten Fotolacks, um eine Fotolack-Struktur (140') zu bilden, wobei ein Fotolack-Durchgangsloch (141) in der Fotolack-Struktur (140') gebildet wird; und Ätzen der ersten initialen Dünnschicht (110') mit dem Fotolack-Durchgangsloch (141) in der Fotolack-Struktur (140') durch einen Ätzprozess, um die erste Dünnschicht (110) und das erste Loch (111) zu bilden, und
eine Abmessung (d4) eines Endabschnitts (141a) des Fotolack-Durchgangslochs (141) nahe dem Basis-Substrat (101) in der voreingestellten Richtung größer ist als die Abmessung (d9) des Strukturbereichs (191) der Maske (190) in der voreingestellten Richtung, oder die Abmessung (d12) des Endabschnitts (111b) des ersten Lochs (111) nahe dem Basis-Substrat (101) in der voreingestellten Richtung durch den Ätzprozess größer gemacht wird als die Abmessung (d9) des Strukturbereichs (191) der Maske (190) in der voreingestellten Richtung.

6. Herstellungsverfahren nach Anspruch 1 oder 2, wobei
der erste Photolithographieprozess aufweist: Belichten der ersten initialen Dünnschicht (110') mit dem Strukturbereich (191) der Maske (190) durch einen Belichtungsprozess; und Entwickeln der belichteten ersten initialen Dünnschicht, um die erste Dünnschicht (110) und das erste Loch (111) zu bilden,
eine Abmessung (d12) eines Endabschnitts (111b) des ersten Lochs (111) nahe dem Basis-Substrat (101) in der vorgegebenen Richtung durch den Belichtungsprozess größer gemacht wird als die Abmessung (d9) des Strukturbereichs (191) der Maske (190) in der vorgegebenen Richtung.

7. Herstellungsverfahren nach einem der Ansprüche 1 bis 6, ferner mit::
vor dem Bilden der dritten Dünnschicht (130), Bilden eines ersten leitenden Abschnitts (151) auf dem Basis-Substrat (101); und
nach dem Bilden der zweiten Dünnschicht (120), Bilden eines zweiten leitenden Abschnitts (152) auf der zweiten Dünnschicht (120), wobei der erste leitende Abschnitt (151) und der zweite leitende Abschnitt (152) durch das dritte Loch (131), das erste Loch (111) und das zweite Loch (121) elektrisch miteinander verbunden sind.

8. Herstellungsverfahren für ein Array-Substrat, mit:
Bilden einer Lochstruktur (100) durch Anwendung des Verfahrens nach einem der Ansprüche 1 bis 7;
vor dem Bilden der dritten Dünnschicht (130) der Lochstruktur (100), Bilden einer ersten elektronischen Komponente (200) auf dem Basis-Substrat (101); und
nach dem Bilden der zweiten Dünnschicht (120) der Lochstruktur (100), Bilden eines zweiten elektronischen Bauelements (300) auf dem Basis-Substrat (101), wobei
die zweite elektronische Komponente (300) und die erste elektronische Komponente (200) durch die Lochstruktur (100) elektrisch miteinander verbunden sind; und
eines von dem ersten elektronischen Bauteil (200) und dem zweiten elektronischen Bauteil (300) einen Transistor aufweist und das andere eine Erfassungseinheit aufweist, und die Erfassungseinheit ein Photodetektor oder ein Strahlungsdetektor ist.

9. Herstellungsverfahren nach Anspruch 8, wobei die Erfassungseinheit aufweist:
eine Pixel-Elektrode (310), die auf dem Basis-Substrat (101) gebildet und mit dem Transistor über die Lochstruktur (100) elektrisch verbunden ist;
eine gemeinsame Elektrode (320), die auf dem Basis-Substrat (101) gebildet ist und von dem Transistor isoliert ist; und
eine Halbleiterstruktur (330), die zwischen der Pixel-Elektrode (310) und der gemeinsamen Elektrode (320) in einer Richtung senkrecht zu dem Basis-Substrat (101) gebildet ist.

10. Lochstruktur mit:
einem Basis-Substrat (101);
einer ersten Dünnschicht (110) aus organischem Isolationsmaterial, die auf dem Basis-Substrat (101) vorgesehen ist und ein erstes Loch (111) aufweist, das ein darin ausgebildetes Durchgangsloch ist, wobei das erste Loch (111) eine Öffnung (111a) auf einer Oberfläche (112) der ersten Dünnschicht (110) weg von dem Basis-Substrat (101) aufweist; und
einer zweiten Dünnschicht (120) aus organischem Isolationsmaterial, die die erste Dünnschicht (110) bedeckt und ein zweites Loch (121) aufweist, das ein darin gebildetes Durchgangsloch ist, wobei das zweite Loch (121) mit dem ersten Loch (111) in Verbindung steht und durch die zweite Dünnschicht (120) verläuft, wobei das zweite Loch (121) eine erste Öffnung (121a) nahe dem Basis-Substrat (101) und eine zweite Öffnung (121b) weg von dem Basis-Substrat (101) aufweist, eine Abmessung (d21) der ersten Öffnung (121a) in einer voreingestellten Richtung parallel zu dem Basis-Substrat (101) kleiner oder gleich einer Abmessung der Öffnung des ersten Lochs (111) in der voreingestellten Richtung ist und kleiner ist als eine Abmessung (d22) der zweiten Öffnung (121b) in der voreingestellten Richtung;
einer dritten Dünnschicht (130) aus organischem Isolationsmaterial, die auf dem Basis-Substrat (101) angeordnet ist,
einem dritten Loch (131), das ein Durchgangsloch ist, das sich in der dritten Dünnschicht (130) befindet, wobei die erste Dünnschicht (110) zwischen der dritten Dünnschicht (130) und der zweiten Dünnschicht (120) und der ersten Dünnschicht (110) angeordnet ist, die zweite Dünnschicht (120) und die dritte Dünnschicht (130) auf der gleichen Seite des Basis-Substrats (101) derart angeordnet sind, dass die dritte Dünnschicht (130) dem Basis-Substrat (101) am nächsten ist, und das erste Loch (111) mit dem dritten Loch (131) derart in Verbindung steht, dass die erste Dünnschicht (110) die Wände des dritten Lochs (131) bedeckt,
wobei
eine Abmessung (d12) eines Endabschnitts (111b) des ersten Lochs (111) nahe dem Basis-Substrat (101) in der voreingestellten Richtung kleiner ist als eine Abmessung (d3) eines Endabschnitts des dritten Lochs (131) nahe dem Basis-Substrat (101) in der voreingestellten Richtung; und
ein geneigter Winkel des ersten Lochs (111), der der zwischen der Wand des Lochs und dem Basis-Substrat außerhalb des Lochs gebildete Winkel ist, kleiner oder gleich 45 Grad ist.

11. Array-Substrat mit:
der Lochstruktur (100) nach Anspruch 10;
einem ersten elektronischen Bauelement (200), das zwischen dem Basis-Substrat (101) und der dritten Dünnschicht (130) der Lochstruktur (100) in einer Richtung senkrecht zum Basis-Substrat (101) vorgesehen ist; und
einem zweiten elektronischen Bauelement (300), das auf einer Seite der zweiten Dünnschicht (120) der Lochstruktur (100) weg von der ersten Dünnschicht (110) vorgesehen ist und elektrisch mit dem ersten elektronischen Bauelement (200) durch die Lochstruktur (100) verbunden ist,
wobei eines von dem ersten elektronischen Bauteil (200) und dem zweiten elektronischen Bauteil (300) einen Transistor aufweist und das andere eine Detektionseinheit aufweist, und die Detektionseinheit ein Photodetektor oder ein Strahlungsdetektor ist.

12. Detektionsvorrichtung, die das Array-Substrat nach Anspruch 11 aufweist.

## Revendications

1. Procédé de fabrication d'une structure à trous, le procédé comprenant :
la formation d'un premier film mince initial (110') qui est réalisé à partir d'un matériau isolant organique sur un substrat de base (101) ;
la réalisation d'un premier processus de photolithographie sur le premier film mince initial (110') à l'aide d'une région à motif (191) d'un masque (190) pour former un premier film mince (110) et un premier trou (111) qui est un trou traversant qui est localisé dans le premier film mince (110), dans lequel le premier trou (111) comporte une ouverture (111a) sur une surface (112) du premier film mince (110) à distance du substrat de base (101) ;
la formation d'un deuxième film mince initial (120') qui est réalisé à partir d'un matériau isolant organique et qui recouvre le premier film mince (110) ; et
la réalisation d'un second processus de photolithographie sur le deuxième film mince initial (120') à l'aide de la région à motif (191) du masque (190) pour former un deuxième film mince (120) et un deuxième trou (121) qui est un trou traversant qui traverse le deuxième film mince (120) et qui communique avec le premier trou (111), dans lequel le deuxième trou (121) comporte une première ouverture (121a) à proximité du substrat de base (101) et une seconde ouverture (121b) à distance du substrat de base (101), et une dimension (d22) de la seconde ouverture (121b) dans une direction prédéfinie parallèle au substrat de base (101) est supérieure à une dimension (d21) de la première ouverture (121a) dans la direction prédéfinie ;
avant la formation du premier film mince (110), la formation d'un troisième film mince (130) qui est réalisé à partir d'un matériau isolant organique sur le substrat de base (101) de telle sorte que le troisième film mince (130), le premier film mince (110) et le deuxième film mince (120) soient disposés dans cet ordre sur le même côté du substrat de base (101), le troisième film mince (130) étant le plus à proximité du substrat de base (101), et la formation d'un troisième trou (131) qui est un trou traversant qui est localisé dans le troisième film mince (130) et qui communique avec le premier trou (111) sur le substrat de base (101) de telle sorte que les parois du troisième trou soient recouvertes par le premier film mince (110) ;
dans lequel :
une dimension (d12) d'une partie d'extrémité (111b) du premier trou (111) à proximité du substrat de base (101) dans la direction prédéfinie est inférieure à une dimension (d3) d'une partie d'extrémité du troisième trou (131) à proximité du substrat de base (101) dans la direction prédéfinie ; et
un angle en pente du premier trou (111), qui est l'angle qui est formé entre la paroi du trou et le substrat de base à l'extérieur du trou, est inférieur ou égal à 45 degrés.

2. Procédé de fabrication selon la revendication 1, dans lequel la dimension (d21) de la première ouverture (121a) du deuxième trou (121) dans la direction prédéfinie est inférieure ou égale à une dimension (d11) de l'ouverture (111a) du premier trou (111) dans la direction prédéfinie.

3. Procédé de fabrication selon la revendication 2, dans lequel la dimension (d21) de la première ouverture (121a) du deuxième trou (121) dans la direction prédéfinie est inférieure ou égale à une dimension (d12) d'une partie d'extrémité (111b) du premier trou (111) à proximité du substrat de base (101) dans la direction prédéfinie.

4. Procédé de fabrication selon l'une quelconque des revendications 1 à 3, dans lequel :
une valeur absolue d'une différence entre une dimension (d9) de la région à motif (191) du masque (190) dans la direction prédéfinie et la dimension (d21) de la première ouverture (121a) du deuxième trou (121) est inférieure ou égale à 4 micromètres.

5. Procédé de fabrication selon la revendication 1 ou 2, dans lequel :
le premier processus de photolithographie inclut : la formation d'une photoréserve (140) qui recouvre le premier film mince initial (110') ; l'exposition de la photoréserve (140) à l'aide de la région à motif (191) du masque (190) ; le développement de la photoréserve exposée pour former un motif de photoréserve (140'), un trou de via de photoréserve (141) étant formé dans le motif de photoréserve (140') ; et la gravure du premier film mince initial (110') à l'aide du trou de via de photoréserve (141) dans le motif de photoréserve (140') au moyen d'un processus de gravure, pour former le premier film mince (110) et le premier trou (111) ; et
une dimension (d4) d'une partie d'extrémité (141a) du trou de via de photoréserve (141) à proximité du substrat de base (101) dans la direction prédéfinie est supérieure à la dimension (d9) de la région à motif (191) du masque (190) dans la direction prédéfinie, ou la dimension (d12) de la partie d'extrémité (111b) du premier trou (111) à proximité du substrat de base (101) dans la direction prédéfinie est rendue supérieure à la dimension (d9) de la région à motif (191) du masque (190) dans la direction prédéfinie au moyen du processus de gravure.

6. Procédé de fabrication selon la revendication 1 ou 2, dans lequel :
le premier processus de photolithographie inclut : l'exposition du premier film mince initial (110') à l'aide de la région à motif (191) du masque (190) au moyen d'un processus d'exposition ; et le développement du premier film mince initial exposé pour former le premier film mince (110) et le premier trou (111) ; et
une dimension (d12) d'une partie d'extrémité (111b) du premier trou (111) à proximité du substrat de base (101) dans la direction prédéfinie est rendue supérieure à la dimension (d9) de la région à motif (191) du masque (190) dans la direction prédéfinie au moyen du processus d'exposition.

7. Procédé de fabrication selon l'une quelconque des revendications 1 à 6, comprenant en outre :
avant la formation du troisième film mince (130), la formation d'une première partie conductrice (151) sur le substrat de base (101) ; et
après la formation du deuxième film mince (120), la formation d'une seconde partie conductrice (152) sur le deuxième film mince (120) ;
dans lequel la première partie conductrice (151) et la seconde partie conductrice (152) sont connectées électriquement l'une à l'autre par l'intermédiaire du troisième trou (131), du premier trou (111) et du deuxième trou (121).

8. Procédé de fabrication d'un substrat de réseau comprenant :
la formation d'une structure à trous (100) en utilisant le procédé selon l'une quelconque des revendications 1 à 7 ;
avant la formation du troisième film mince (130) de la structure à trous (100), la formation d'un premier composant électronique (200) sur le substrat de base (101) ; et
après la formation du deuxième film mince (120) de la structure à trous (100), la formation d'un second composant électronique (300) sur le substrat de base (101) ;
dans lequel :
le second composant électronique (300) et le premier composant électronique (200) sont connectés électriquement l'un à l'autre par l'intermédiaire de la structure à trous (100) ; et
un composant électronique parmi le premier composant électronique (200) et le second composant électronique (300) inclut un transistor et l'autre composant électronique inclut une unité de détection, et l'unité de détection est un photodétecteur ou un détecteur de rayonnement.

9. Procédé de fabrication selon la revendication 8, dans lequel l'unité de détection inclut :
une électrode de pixel (310) qui est formée sur le substrat de base (101) et qui est connectée électriquement au transistor par l'intermédiaire de la structure à trous (100) ;
une électrode commune (320) qui est formée sur le substrat de base (101) et qui est isolée du transistor ; et
une structure semiconductrice (330) qui est formée entre l'électrode de pixel (310) et l'électrode commune (320) dans une direction perpendiculaire au substrat de base (101).

10. Structure à trous comprenant :
un substrat de base (101) ;
un premier film mince (110) qui est réalisé à partir d'un matériau isolant organique, qui est prévu sur le substrat de base (101) et qui comporte un premier trou (111), lequel est un trou traversant formé en son sein, dans lequel le premier trou (111) comporte une ouverture (111a) sur une surface (112) du premier film mince (110) à distance du substrat de base (101) ; et
un deuxième film mince (120) qui est réalisé à partir d'un matériau isolant organique, qui recouvre le premier film mince (110) et qui comporte un deuxième trou (121), lequel est un trou traversant formé en son sein, le deuxième trou (121) communiquant avec le premier trou (111) et traversant le deuxième film mince (120), dans lequel le deuxième trou (121) comporte une première ouverture (121a) à proximité du substrat de base (101) et une seconde ouverture (121b) à distance du substrat de base (101), une dimension (d21) de la première ouverture (121a) dans une direction prédéfinie parallèle au substrat de base (101) est inférieure ou égale à une dimension de l'ouverture du premier trou (111) dans la direction prédéfinie et est inférieure à une dimension (d22) de la seconde ouverture (121b) dans la direction prédéfinie ; et
un troisième film mince (130) qui est réalisé à partir d'un matériau isolant inorganique, qui est disposé sur le substrat de base (101) et qui comporte un troisième trou (131), lequel est un trou traversant qui est localisé dans le troisième film mince (130) ;
dans lequel :
le premier film mince (110) est agencé entre le troisième film mince (130) et le deuxième film mince (120), et le premier film mince (110), le deuxième film mince (120) et le troisième film mince (130) sont disposés sur le même côté du substrat de base (101) de telle sorte que le troisième film mince (130) soit le plus à proximité du substrat de base (101), et le premier trou (111) communique avec le troisième trou (131) de telle sorte que le premier film mince (110) recouvre les parois du troisième trou (131) ; et
dans lequel :
une dimension (d12) d'une partie d'extrémité (111b) du premier trou (111) à proximité du substrat de base (101) dans la direction prédéfinie est inférieure à une dimension (d3) d'une partie d'extrémité du troisième trou (131) à proximité du substrat de base (101) dans la direction prédéfinie ; et
un angle en pente du premier trou (111), qui est l'angle qui est formé entre la paroi du trou et le substrat de base à l'extérieur du trou, est inférieur ou égal à 45 degrés.

11. Substrat de réseau comprenant :
la structure à trous (100) selon la revendication 10 ;
un premier composant électronique (200) qui est prévu entre le substrat de base (101) et le troisième film mince (130) de la structure à trous (100) dans une direction perpendiculaire au substrat de base (101) ; et
un second composant électronique (300) qui est prévu sur un côté du deuxième film mince (120) de la structure à trous (100) à distance du premier film mince (110) et qui est connecté électriquement au premier composant électronique (200) par l'intermédiaire de la structure à trous (100) ;
dans lequel un composant électronique parmi le premier composant électronique (200) et le second composant électronique (300) inclut un transistor et l'autre composant électronique inclut une unité de détection, et l'unité de détection est un photodétecteur ou un détecteur de rayonnement.

12. Dispositif de détection comprenant le substrat de réseau selon la revendication 11.
